# EUROPEAN PATENT APPLICATION

(11) **EP 4 343 834 A1**
(43) Date of publication of application: **27.03.2024**
(21) Application number: 23190771.8
(22) Date of filing: 10.08.2023
(51) Int. Cl.: H01L 23/525

(54) **ALTERING OPERATIONAL CHARACTERISTICS OF A SEMICONDUCTOR DEVICE USING ACCELERATED IONS**

(30) Priority: 23.09.2022 US 202217951995
(71) Applicant: INTEL Corporation, Santa Clara, CA 95054 (US)
(72) Inventor: TAN, Shida, Saratoga, 95070 (US); LIVENGOOD, Richard H., San Jose, 95135 (US)
(74) Representative: HGF

(57) **Abstract**

Embodiments described herein may be related to apparatuses, processes, systems, and/or techniques for altering an operational characteristic of a semiconductor device by exposing one or more locations within the semiconductor device to a focused ion beam. In embodiments, the ions in the focused ion beam may be light-element ions, which may include helium ions or neon ions. Other embodiments may be described and/or claimed.

## Description

### FIELD

Embodiments of the present disclosure generally relate to the field of semiconductor manufacturing, and in particular to changing operational characteristics of a semiconductor device after manufacture.

### BACKGROUND

Continued growth in virtual machines, cloud computing, and portable devices will continue to increase the demand for high density transistors within chips and packages. In addition, there will be an increased need for high quality components with an improved efficiency in identifying defects within semiconductor or other devices.

### BRIEF DESCRIPTION OF THE DRAWINGS

FIG. 1 shows cross-section side views of a semiconductor device with front side metal layers and back side metal layers on either side of a transistor layer, in accordance with various embodiments.
FIG. 2 shows a cross section side view of legacy implementation for altering an operational characteristic of a semiconductor device after manufacture.
FIG. 3 shows cross-section side views of a semiconductor device and a focused ion beam (FIB) used to alter the characteristics of a transistor within the semiconductor device, in accordance with various embodiments.
FIG. 4 shows a cross section side view of a semiconductor device on a carrier wafer, with a portion of the carrier wafer removed so that an ion beam from an FIB generator may be used to alter the characteristics of a transistor within the semiconductor device, in accordance with various embodiments.
FIG. 5 shows a cross section side view of a semiconductor device and a FIB used to implant ions to create a defect within the semiconductor device, in accordance with various embodiments.
FIG. 6 shows a cross section side view of a semiconductor device on a carrier wafer, with a portion of the carrier wafer removed so that an ion beam from an FIB generator may be used to create a defect within a semiconductor device, in accordance with various embodiments.
FIG. 7 shows a top-down cross-section of a transistor layer of a semiconductor device with multiple locations where an ion beam from a FIB generator may be used to create defects within the semiconductor device, in accordance with various embodiments.
FIG. 8 illustrates an example process for altering operational characteristics of a semiconductor device after manufacture, in accordance with various embodiments.
FIG. 9 illustrates a computing device in accordance with one implementation of the invention.
FIG. 10 illustrates an interposer that includes one or more embodiments of the invention.

### DETAILED DESCRIPTION

Embodiments described herein may be related to apparatuses, processes, systems, and/or techniques for altering an operational characteristic of a semiconductor device after manufacture by exposing one or more locations within the semiconductor device to ions. In embodiments, these ions may be light-element ions, which may include helium ions, lithium ions, hydrogen ions, argon ions, nitrogen ions, oxygen ions, silicon ions, boron ions, carbon ions, argon ions, or neon ions. In embodiments, these ions may be focused on the one or more locations within the semiconductor device using a focused ion beam (FIB) generator.

In embodiments, the effect that the ions have on the semiconductor device may vary based upon the species of ion selected, a shape of the ion beam, the distance of a focal point between the FIB generator and a location within the semiconductor device, and/or an energy level or acceleration of the ion beam. In embodiments, the effects to the one or more locations within the semiconductor device may range widely.

In non-limiting examples, defects may be introduced, or injected, within the semiconductor device in order to validate testing procedures for the semiconductor device. In another example, transistor structures within the semiconductor device may be tuned. In another example, timings within electrical circuitry of the semiconductor device may be tuned. In another example, electrical circuitry and/or transistor components may be cut. In another example, the ion beam may introduce voids within the semiconductor device to disconnect or disrupt signals within the semiconductor device. In another example, the ion beam may modify parasitic characteristics of the semiconductor device that may include resistance, dielectric constant, capacitance, and/or inductance.

In each of these examples of embodiments, these alterations of operational characteristics of the semiconductor device may be performed without physically removing any metal layers of the semiconductor device or otherwise deconstructing the semiconductor device. In embodiments, these techniques using ion beams may also be used to alter circuitry and/or transistor components that may be surrounded by one or more metal layers on either side of the circuitry and/or transistor components.

For example, in embodiments, sub-surface signal routing cuts may be performed using an ion beam within a semiconductor device for circuit rewiring or to produce targeted defect injections for later semiconductor device testing. In embodiments, a signal routing cut may be performed by using the ion beam to create a nano-bubble where the cut is intended. Location of the nano-bubble may be determined by a stopping depth of the ion beam, which may be adjusted by controlling beam acceleration energy. The formation of the nano-bubble, or other defect, may be controlled through the ion landing energy and the ion dose to precisely alter the device performance and/or terminate the signal routing. These techniques may be performed through one or more metal layers of the semiconductor device without having to first deconstruct these layers.

In embodiments, the timing of a semiconductor device may be changed by performing a direct-write implant of ions into one or more transistor channels, for example a RibbonFET^{™} channel, which results in a change in parasitic characteristics of the device, or by reducing the drive strength of the device. In embodiments, these techniques may be used with FinFET devices, dual-gate devices, planar transistors, or any other form of semiconductor devices. For example, a timing shift may be performed by adding a capacitive load to the device, or by routing the device through a highly resistive FIB wire or spare buffer. In embodiments, the FIB wire may be used to implant defects into the semiconductor device to alter the resistivity of an existing metal wire. In embodiments, these techniques may be used to create a direct and/or permanent timing shift by changing the device channel properties, by removing one of the device channel properties and/or by removing one of the device channels.

In embodiments, a stopping depth of an ion beam may be attenuated by controlling beam landing energy on the semiconductor device. The degree of the alteration performed, for example crystalline structure alteration, amorphous structure alteration, defect density, defect distribution, or nano-bubble formation, may be controlled through a combination of ion beam energy, ion beam species, ion dose, ion dose rate, and temperature of the environment and/or semiconductor device. In embodiments, the interaction between ions and the semiconductor device may be largely electronic at high velocities of the ion beam, where there are no nuclear collisions and the ions just pass through the lattice of other atoms. However, the interaction between ions in the semiconductor device may transition to a nuclear collision as the ions lose energy near the stopping depth.

In embodiments, the techniques described herein may be used during product design and manufacture, particularly with respect to prototyping, where part of validating design changes include generating engineering samples and to debug design/process marginality and logic issues. These techniques may be performed on semiconductor devices, or devices in general that may include package devices or on die devices at a pre-assembly level. These techniques may also be applied during various stages of the manufacturing process, including during the frontend or the backend manufacturing process.

Legacy implementations have implemented design changes to semiconductor devices by using machining tools to machine through a silicon substrate of the device down to a transistor or circuit level, which may be referred to as deconstruction, and rewiring the transistor interconnects or circuitry to implement a logic change. In legacy implementations, timing changes were done by adding capacitance or resistance to a node, for example, after deconstruction, by rerouting signals through a buffer or an inverter using direct write machining and/or depositions. In legacy implementations, other devices, which may be referred to as bonus devices, may include the buffer or the inverter, where rerouting of signals is accomplished by depositing dielectric material and/or metal.

However, these legacy techniques are no longer applicable or are too invasive due to higher aspect ratio machining geometries, and therefore not effective for semiconductor devices that include RibbonFET^{™} transistor structures, transistor structures that have increased placement density, or devices that have multiple metal layers on both sides of transistor or other circuitry.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

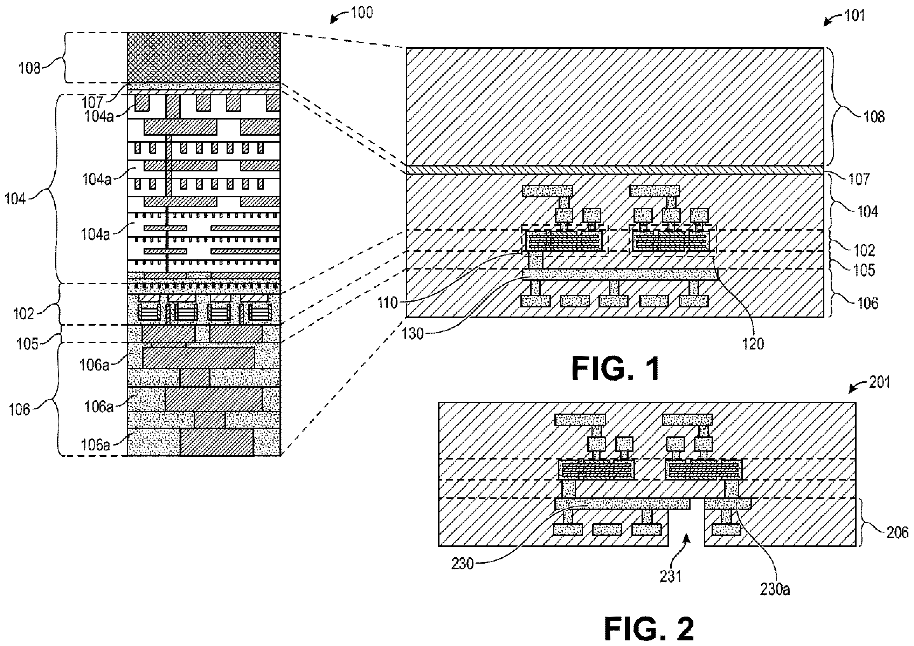

FIG. 1 shows cross-section side views of a semiconductor device with front side metal layers and back side metal layers on either side of a transistor layer, in accordance with various embodiments. Semiconductor device 100 illustrates a cross-section side view that includes a transistor layer 102, with a front side interconnect layer 104, which may be referred to as a front side metal layer stack, on top of the transistor layer 102. The front side interconnect layer 104 may have multiple metal layers 104a.

A routing layer 105 may be below the transistor layer 102, and may include one or more metal routings. A back side interconnect layer 106, which may be referred to as back side metal layers, may be below the transistor layer 102 and the routing layer 105, and may have multiple metal layers 106a. A carrier wafer 108, which may include silicon, may be physically coupled with the front side interconnect layer 104 using bonding oxides 107.

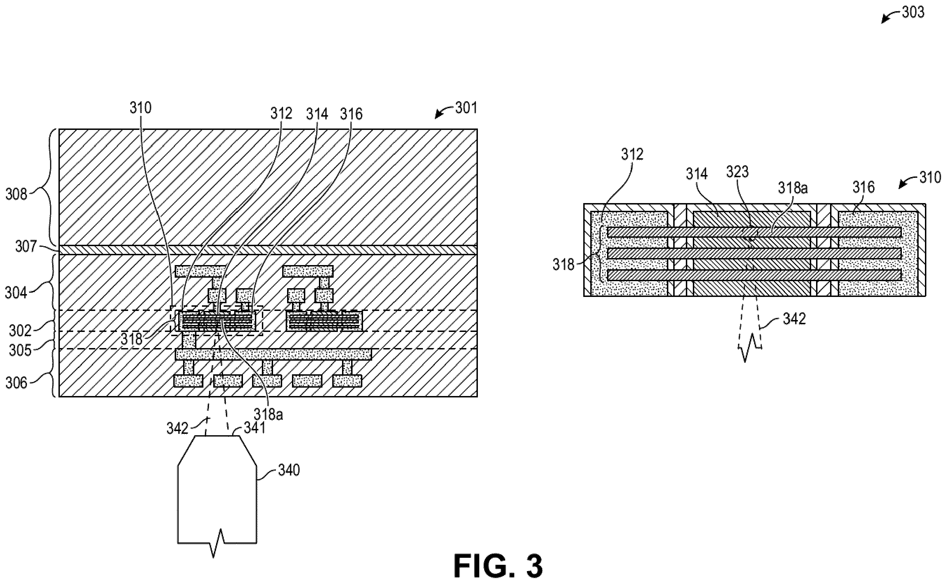

Diagram 101, which is an illustration similar to semiconductor device 100, includes a carrier wafer 108, bonding oxides 107, front side interconnect layer 104, transistor layer 102, routing layer 105, and back side interconnect layer 106. The transistor layer 102 shows a first transistor structure 110 and a second transistor structure 120. In addition, the back side interconnect layer 106 may include a metal routing 130. Transistor structures 110, 120 and metal routing 130 are described in greater detail in FIG. 3.

FIG. 2 shows a cross section side view of legacy implementation for altering an operational characteristic of a semiconductor device after manufacture. Diagram 201, which may be similar diagram 101 of FIG. 1, shows a portion of a semiconductor device, which may be similar to semiconductor device 100 of FIG. 1. In legacy implementations, a back side interconnect layer 206, which may be similar to back side interconnect layer 106 of FIG. 1, has had a cavity 231 created in a side of the back side interconnect layer 206 and through a metal routing 230, which may be referred to as metal circuitry, which may be similar to metal routing 130 of FIG. 1.

In implementations, the cavity 231 may be formed using a mechanical process in order to expose the metal routing 230 and to electrically isolate a portion of the metal routing 230a. In other implementations, the cavity 231 may be used to create a fuse structure (not shown) within the metal routing 230. In still other implementations, the cavity 231, after it is created, may then provide access for electrical connections to be formed between other electrical elements (not shown). In other implementations, various defects and/or other alterations (not shown) of operational characteristics of the device represented by diagram 201 may be performed. In these legacy implementations, forming cavity 231 may be very expensive, and may limit the number of alterations of operational characteristics that may be performed. In addition, the ability to form a cavity without damaging the functionality of the semiconductor device is low.

FIG. 3 shows cross-section side views of a semiconductor device and a FIB used to alter the characteristics of a transistor within the semiconductor device, in accordance with various embodiments. Diagram 301, which may be similar to diagram 101 of FIG. 1 that shows a portion of semiconductor device 100 of FIG. 1, includes a carrier wafer 308, bonding oxide 307, front side interconnect layer 304, transistor layer 302, routing layer 305, and back side interconnect layer 306. These may be similar to carrier wafer 108, bonding oxide 107, front side interconnect layer 104, transistor layer 102, routing layer 105, and back side interconnect layer 106 of FIG. 1.

The transistor layer 302 includes transistor structure 310, which may be similar to transistor structure 110 of FIG. 1. Transistor structure 310 includes a source 312, a gate 314, a drain 316, and channels 318. In embodiments, a FIB generator 340 may be used to generate an ion beam 342 that is focused onto location 323 within channel 318a of the channels 318. In embodiments, the ion beam 342 may have a conical shape. In embodiments, the location 323 may have a dimension that is less than 1 nanometer.

In embodiments, the exposure of the ion beam 342 onto the location 323 will change the crystalline structure of the channel 318a within location 323 by implanting ions. As a result, this crystalline structure change will change the threshold voltage (Vt) and/or other parasitics, such as resistance, dielectric constant, capacitance, and/or inductance, for the channel 318a, as well as for the transistor structure 310. In embodiments, the ion beam 342 may include high-energy ions that are able to extend through the metal layers and dielectric layers of the back side interconnect layer 306. As a result, at least some of the ions from the ion beam 342 will stop at location 323 thus causing a crystalline structure change. The amount of the ion dose at the location 323 may be used to control crystalline structure change, and therefore control the amount of timing shift experienced by the channel 318a during operation. Diagram 303 shows an expanded view of transistor structure 310. In embodiments the crystalline structure described herein may also be an amorphous structure, or a mix of crystalline structure and amorphous structure.

In embodiments, the location 323, onto which the ion beam 342 is focused, may be determined based on several factors. For example, some of these factors may include the selected species of ion, for example, helium or neon, the shape of the ion beam 342, and the distance between the lens 341 of the FIB generator 340 and the location 323. Another factor may include the energy level of the ion beam generated by the FIB generator 340. For example, higher-energy ions may more readily pass through metals. Other factors may include characteristics of any material, such as the back side interconnect layer 306, routing layer 305, and transistor layer 302, that may cause the ions within the ion beam 342 to either slow down, or begin to bounce back. In embodiments, the ion beam 342 may enter into other materials that may include a backside interconnect layer (not shown), where the ion beam 342 will dislocate substrate materials and straggle through the materials.

In embodiments, the location 323 may be determined by altering the energy in the ion beam 342, to control or attenuate a stopping range or a density of ions within the ion beam 342 in order to determine a depth of the location 323 and the resulting characteristics at the location 323. In embodiments, both the energy and the ion beam 342 and the dose or duration of time of the exposure by the ion beam 342 will control a position of and resulting characteristics at the location 323.

Although the location 323 is shown within channel 318a, in embodiments location 323 may also include a number of channels 318. In embodiments, the location 323 may be selected to include any other location and/or structure within the semiconductor device 100 of FIG. 1, that may not include one or more of the channels 318, in order to alter operational characteristics of the semiconductor device shown in diagram 301.

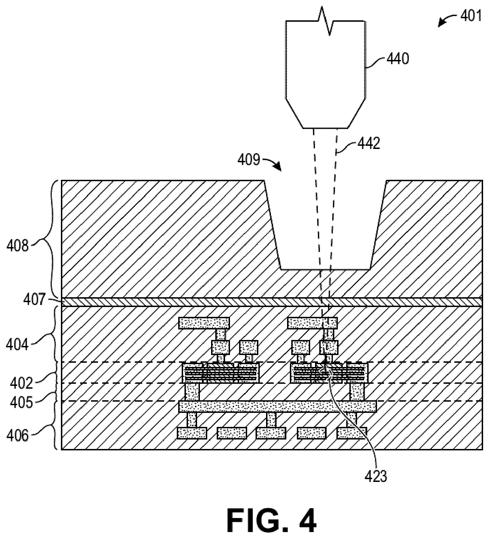

FIG. 4 shows a cross section side view of a semiconductor device on a carrier wafer, with a portion of the carrier wafer removed so that an ion beam from an FIB generator may be used to alter the characteristics of a transistor within the semiconductor device, in accordance with various embodiments. Diagram 401, which may be similar to diagram 301 of FIG. 3, shows a carrier wafer 408, bonding oxide 407, front side interconnect layer 404, transistor layer 402, routing layer 405, and back side interconnect layer 406, which may be similar to carrier wafer 308, bonding oxide 307, front side interconnect layer 304, transistor layer 302, routing layer 305, and back side interconnect layer 306 of FIG. 3.

A FIB generator 440, which may be similar to FIB generator 340 of FIG. 3, may be placed above the carrier wafer 408, with the ion beam 442 focused on the location 423 within the transistor layer 402. In embodiments, a cavity 409 may be created within the carrier wafer 408. In embodiments, the cavity 409 may be created using focused ion beam machining, or other mechanical machining techniques. The cavity 409 may reduce the distance of the ion beam 442 that extends through the carrier wafer, therefore increasing the energy level of the ions that reach the location 423. In other embodiments, cavity 409 may extend into structures, for example into metal structures within the front side interconnect layer 404, or transistor structures within the transistor layer 402 (not shown).

In some embodiments, these techniques may be performed in situ at the wafer level during the semiconductor device manufacturing process. In other embodiments, these techniques may be implemented with, or may be used in combination with, other beam-based direct write technologies, such as neutral particle beam matching, electron beams, or proton beams.

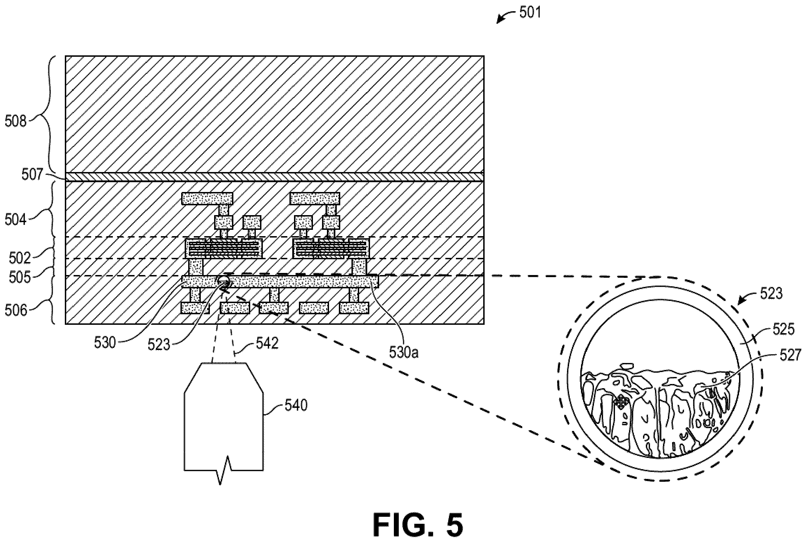

FIG. 5 shows a cross section side view of a semiconductor device and a FIB used to implant ions to create a defect within the semiconductor device, in accordance with various embodiments. Diagram 501, which may be similar to diagram 101 of FIG. 1 that shows a portion of semiconductor device 100 of FIG. 1, includes a carrier wafer 508, bonding oxide 507, front side interconnect layer 504, transistor layer 502, routing layer 505, and back side interconnect layer 506. These may be similar to carrier wafer 108, bonding oxide 107, front side interconnect layer 104, transistor layer 102, routing layer 105, and back side interconnect layer 106 of FIG. 1.

The back side interconnect layer 506 may include a metal routing 530, which may be similar to metal routing 130 of FIG. 1. In embodiments, a modification 523 may be made within the metal routing 530, in order to electrically isolate metal routing section 530a and metal routing 530 from each other. In other embodiments, the modification 523 may create a fuse structure (not shown) that may still cause metal routing section 530a and metal routing 530 to be electrically coupled.

In embodiments, the FIB generator 540, which may be similar to FIB generator 340 of FIG. 3, may be used to generate an ion beam 542. The ion beam 542 may generate high-energy/high velocity ions that stop proximate to the modification 523. In embodiments, the ion beam 542 may use light element ion beams, such as helium, neon, lithium, beryllium, silicon, proton, hydrogen, boron, oxygen, carbon, argon, or the like. In embodiments, light element ions may use a lower energy, for example less than 10 keV, and may not need to have a high energy, for example 100 keV, needed for larger ions such as gallium, xenon, gold, or cesium, in order to reach the modification 523. In contrast, larger ions may just crash into the surface of the back side interconnect layer 506, and may implant only 10 nm into the surface, not reaching the modification 523. In this embodiment, the modification 523 may be 100 nm or more beyond the surface of the back side interconnect layer 506.

The modification 523 may include a nano-bubble, which may be referred to as a cavity, that is formed when the ions within the ion beam 542 come to rest. As a result, individual atoms that are associated with the ions, or ion atoms, for example helium atoms or neon atoms, may be in atom clusters 525 around the modification 523. In embodiments, other material 527 may be formed within the modification 523. In embodiments, the other material 527 may include clusters of implanted materials by the ion beam 542. In other embodiments (not shown) the modification 523 may include other types of defects other than a nano-bubble. In embodiments, the location of the modification 523 may be selected by controlling the acceleration energy of the ion beam 542. A structure of the resulting modification 523, such as a nano-bubble, may be controlled through the energy of the ion beam and the dose, or the actual number of ions that come to rest proximate to the modification 523.

Although in this embodiment the modification 523 is shown within the metal routing 530, the modification 523, or example nano-bubble, may be produced anywhere within the semiconductor device 100 of FIG. 1 to alter the operational characteristics of the semiconductor device 100. In embodiments, these techniques can be used in conjunction with other ion beam-based direct write technologies, such as neutral particle beam machining, ion beams, electron beams, or proton beams.

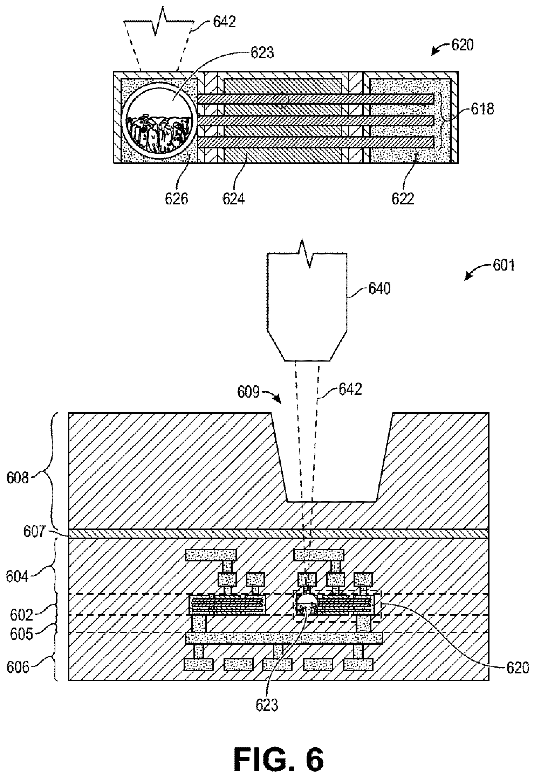

FIG. 6 shows a cross section side view of a semiconductor device on a carrier wafer, with a portion of the carrier wafer removed so that an ion beam from an FIB may be used to create a defect within a semiconductor device, in accordance with various embodiments. Diagram 601, which may be similar to diagram 501 of FIG. 5, shows a carrier wafer 608, bonding oxide 607, front side interconnect layer 604, transistor layer 602, routing layer 605, and back side interconnect layer 606, which may be similar to carrier wafer 508, bonding oxide 507, front side interconnect layer 504, transistor layer 502, routing layer 505, and back side interconnect layer 506 of FIG. 5. The transistor layer 602 may include a transistor structure 620 that includes a source 622, a gate 624, and a drain 626.

A FIB generator 640, which may be similar to FIB generator 540 of FIG. 5, may be placed above the carrier wafer 608, with the ion beam 642 focused on the modification 623 within the transistor layer 602. In this embodiment, the modification 623 corresponds to the drain 626 within this transistor structure 620, where the modification is to remove a substantial portion of the drain 626 that is coupled with channels 618, which may be similar to channels 318 of FIG. 3. In embodiments, the modification 623 may be a nano-bubble similar to that discussed above with respect to FIG. 5.

In embodiments, a cavity 609 may be created within the carrier wafer 608. In embodiments, the cavity 609 may be created using focused ion beam machining, or other mechanical machining techniques. The cavity 609 may reduce the distance of the ion beam 642 that extends through the carrier wafer, therefore increasing the energy level of the ions that reach the modification 623. In other embodiments, cavity 609 may extend into structures, for example into metal structures within the front side interconnect layer 604, or other transistor structures within the transistor layer 602 (not shown).

In some embodiments, these techniques may be performed in situ at the wafer level during the semiconductor device manufacturing process. In other embodiments, these techniques may be implemented with, or may be used in combination with, other beam-based direct write technologies, such as neutral particle beam the matching, or proton beams.

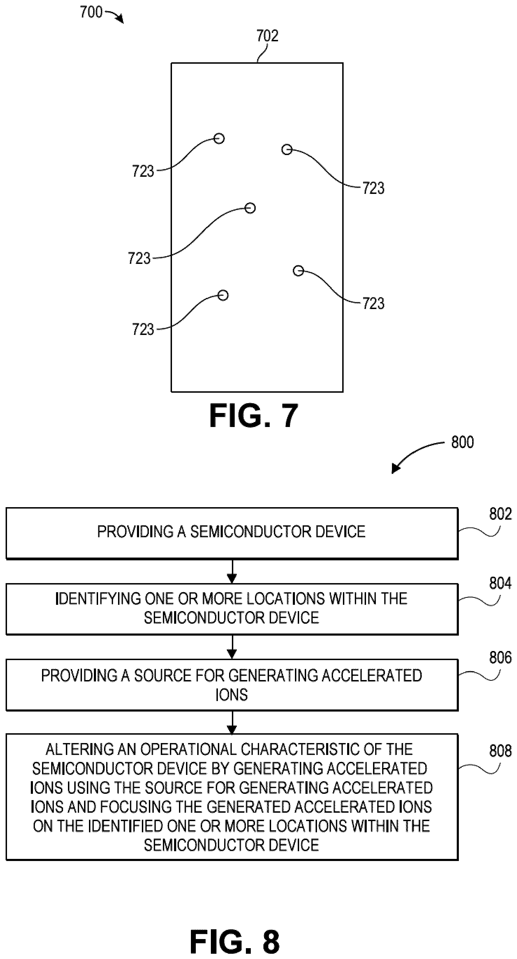

FIG. 7 shows a top-down cross-section of transistor layer of a semiconductor device with multiple locations where an ion beam from a FIB may be used to create defects within the semiconductor device, in accordance with various embodiments. Diagram 700 shows a top-down cross-section view of a transistor layer 702, which may be similar to transistor layer 602 of FIG. 6. In embodiments, a plurality of modifications 723, which may be similar to modification 623 of FIG. 6, may be made within the transistor layer 702. In embodiments, the plurality of modifications 723 may be used by moving a FIB generator such as FIB generator 640 of FIG. 6, in relation to the transistor layer 702.

FIG. 8 illustrates an example process for altering operational characteristics of a semiconductor device after manufacture, in accordance with various embodiments. Process 800 may be performed using the tools, techniques, systems, processes and/or apparatus described herein, and in particular with respect to FIGs. 1-7.

At block 802, the process may include providing a semiconductor device. In embodiments, the semiconductor device may be similar to semiconductor device 100 of FIG. 1, or the semiconductor device as shown with respect to diagram 101 of FIG. 1, diagram 301 of FIG. 3, diagram 401 of FIG. 4, diagram 501 of FIG. 5, diagram 601 of FIG. 6, or diagram 700 of FIG. 7.

At block 804, the process may further include identifying one or more locations within the semiconductor device. In embodiments, the one or more locations may be similar to location 323 of FIG. 3, location 423 of FIG. 4, modification 523 of FIG. 5, or modification 623 of FIG. 6.

At block 806, the process may further include providing a source for generating accelerated ions. In embodiments, the source for generating accelerated ions may be similar to FIB generator 340 of FIG. 3, FIB generator 440 of FIG. 4, FIB generator 540 of FIG. 5, or FIB generator 640 of FIG. 6.

At block 808, the process may further include altering an operational characteristic of the semiconductor device by generating accelerated ions using the source for generating accelerated ions and focusing the generated accelerated ions on the identified one or more locations within the semiconductor device. In embodiments, the generated accelerated ions may be similar to ion beam 342 of FIG. 3, ion beam 442 of FIG. 4, ion beam 542 of FIG. 5, or ion beam 642 of FIG. 6.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

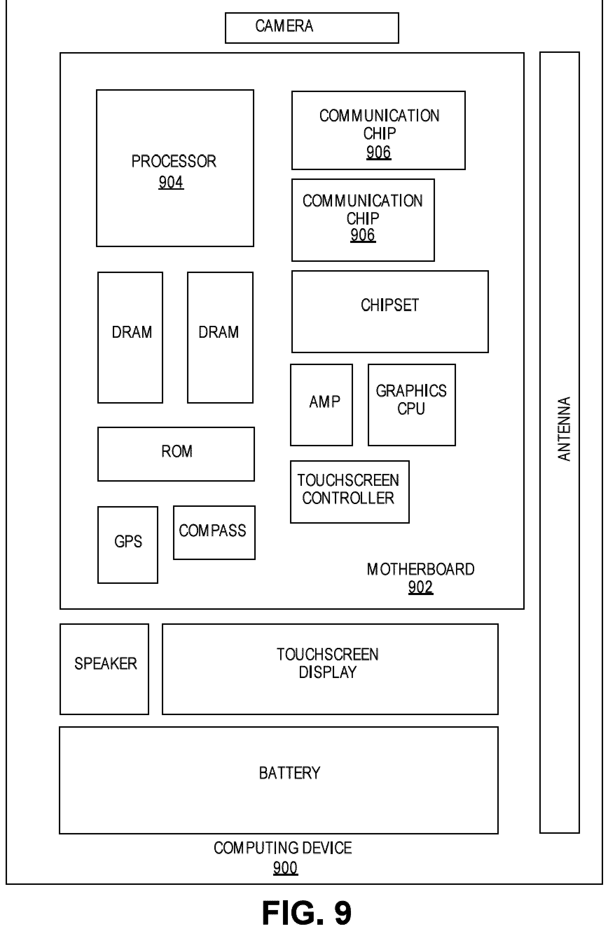

FIG. 9 illustrates a computing device 900 in accordance with one implementation of the invention. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of the invention, the integrated circuit die of the communication chip includes one or more devices, such as MOS-FET transistors built in accordance with implementations of the invention.

In further implementations, another component housed within the computing device 900 may contain an integrated circuit die that includes one or more devices, such as MOS-FET transistors built in accordance with implementations of the invention.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

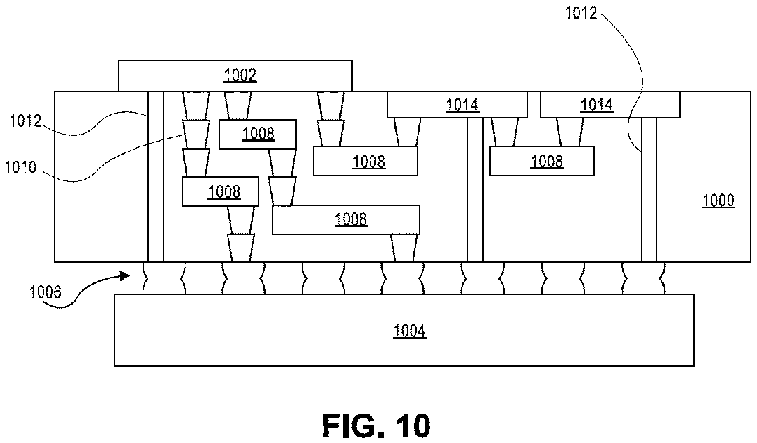

FIG. 10 illustrates an interposer 1000 that includes one or more embodiments of the invention. The interposer 1000 is an intervening substrate used to bridge a first substrate 1002 to a second substrate 1004. The first substrate 1002 may be, for instance, an integrated circuit die. The second substrate 1004 may be, for instance, a memory module, a computer motherboard, or another integrated circuit die. Generally, the purpose of an interposer 1000 is to spread a connection to a wider pitch or to reroute a connection to a different connection. For example, an interposer 1000 may couple an integrated circuit die to a ball grid array (BGA) 1006 that can subsequently be coupled to the second substrate 1004. In some embodiments, the first and second substrates 1002/1004 are attached to opposing sides of the interposer 1000. In other embodiments, the first and second substrates 1002/1004 are attached to the same side of the interposer 1000. And in further embodiments, three or more substrates are interconnected by way of the interposer 1000.

The interposer 1000 may be formed of an epoxy resin, a fiberglass-reinforced epoxy resin, a ceramic material, or a polymer material such as polyimide. In further implementations, the interposer 1000 may be formed of alternate rigid or flexible materials that may include the same materials described above for use in a semiconductor substrate, such as silicon, germanium, and other group III-V and group IV materials.

The interposer 1000 may include metal interconnects 1008 and vias 1010, including but not limited to through-silicon vias (TSVs) 1012. The interposer 1000 may further include embedded devices 1014, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1000. In accordance with embodiments of the invention, apparatuses or processes disclosed herein may be used in the fabrication of interposer 1000.

Although certain embodiments have been illustrated and described herein for purposes of description, a wide variety of alternate and/or equivalent embodiments or implementations calculated to achieve the same purposes may be substituted for the embodiments shown and described without departing from the scope of the present disclosure. This application is intended to cover any adaptations or variations of the embodiments discussed herein. Therefore, it is manifestly intended that embodiments described herein be limited only by the claims.

Where the disclosure recites "a" or "a first" element or the equivalent thereof, such disclosure includes one or more such elements, neither requiring nor excluding two or more such elements. Further, ordinal indicators (e.g., first, second or third) for identified elements are used to distinguish between the elements, and do not indicate or imply a required or limited number of such elements, nor do they indicate a particular position or order of such elements unless otherwise specifically stated.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

Example 1 is a semiconductor device comprising: one or more substrate layers; electrical circuitry in at least one of the one or more substrate layers; and a cavity proximate to the electrical circuitry, wherein the cavity extends into at least a portion of the electrical circuitry.

Example 2 includes the semiconductor device of example 1, further comprising a plurality of ion atoms proximate to the cavity.

Example 3 includes the semiconductor device of example 2, wherein the plurality of ion atoms include a selected one or more of: helium, lithium, hydrogen, argon, nitrogen, oxygen, silicon, boron, carbon, argon, or neon atoms.

Example 4 includes the semiconductor device of examples 1, 2, or 3, wherein the cavity is proximate to a dielectric layer.

Example 5 includes the semiconductor device of examples 1, 2, 3, or 4, wherein the cavity is at least partially filled with implanted ions.

Example 6 includes the semiconductor device of examples 1, 2, 3, 4, or 5, wherein the electrical circuitry includes a selected one or more of: a metal routing or a portion of a transistor structure.

Example 7 includes the semiconductor device of examples 1, 2, 3, 4, 5, or 6, wherein the cavity electrically isolates a first part of the electrical circuitry from a second part of the electrical circuitry.

Example 8 includes the semiconductor device of examples 1, 2, 3, 4, 5, 6, or 7, wherein the semiconductor device has a first side and a second side opposite the first side, and wherein the cavity has a distance from the first side or the second side that is greater than 100 nm.

Example 9 is a semiconductor device comprising: one or more substrate layers; a transistor structure within the one or more substrate layers, wherein the transistor structure includes a source, a channel, and a drain; and wherein a first location within the channel includes a material with a first crystalline structure or a first amorphous structure, and wherein a second location within the channel includes the material with a second crystalline structure or a second amorphous structure, and wherein the first crystalline structure or the first amorphous structure is different than the second crystalline structure or the second amorphous structure.

Example 10 includes the semiconductor device of example 9, further comprising a plurality of ions proximate to the second crystalline structure.

Example 11 includes the semiconductor device of example 10, wherein the plurality of ions include a selected one or more of: include a selected one or more of: helium, lithium, hydrogen, argon, nitrogen, oxygen, silicon, boron, carbon, argon, or neon ions.

Example 12 includes the semiconductor device of examples 9, 10, or 11, wherein the second crystalline structure or the second amorphous structure is formed using a focused ion beam.

Example 13 includes the semiconductor device of examples 9, 10, 11, or 12, wherein the second crystalline structure or the second amorphous structure alters a timing of the transistor structure.

Example 14 includes the semiconductor device of examples 9, 10, 11, 12, or 13, wherein the second crystalline structure or the second amorphous structure alters a threshold voltage (Vt) of the transistor structure.

Example 15 includes the semiconductor device of examples 9, 10, 11, 12, 13 or 14, further comprising: a first plurality of metal layers on a first side of the transistor structure; and a second plurality of metal layers on a second side of the transistor structure opposite the first side of the transistor structure.

Example 16 is a method comprising: providing a semiconductor device; identifying one or more locations within the semiconductor device; providing a source for generating accelerated ions; and altering an operational characteristic of the semiconductor device by generating accelerated ions using the source for generating accelerated ions and focusing the generated accelerated ions on the identified one or more locations within the semiconductor device.

Example 17 includes the method of example 16, wherein the source for generating accelerated ions includes a focused ion beam generator.

Example 18 includes the method of examples 16 or 17, wherein the one or more locations within the semiconductor device includes a selected one or more of: metal circuitry or a transistor structure.

Example 19 includes the method of examples 16, 17, or 18, wherein the generated accelerated ions include a selected one or more of: helium, lithium, hydrogen, argon, nitrogen, oxygen, silicon, boron, carbon, argon, or neon ions.

Example 20 includes the method of examples 16, 17, 18, or 19, wherein generating accelerated ions further includes: identifying a species of ion; and configuring an energy of the generated accelerated ions.

Example 21 includes the method of examples 16, 17, 18, 19, or 20, wherein generating accelerated ions further includes identifying a shape of a beam of the generated accelerated ions.

Example 22 includes the method of examples 16, 17, 18, 19, 20, or 21, wherein generating accelerated ions further includes generating accelerated ions for a duration of time.

## Claims

1. A semiconductor device comprising:
one or more substrate layers;
electrical circuitry in at least one of the one or more substrate layers; and
a cavity proximate to the electrical circuitry, wherein the cavity extends into at least a portion of the electrical circuitry.

2. The semiconductor device of claim 1, further comprising a plurality of ion atoms proximate to the cavity.

3. The semiconductor device of claim 2, wherein the plurality of ion atoms include a selected one or more of: helium, lithium, hydrogen, argon, nitrogen, oxygen, silicon, boron, carbon, argon, or neon atoms.

4. The semiconductor device of claim 1, 2 or 3, wherein the cavity is proximate to a dielectric layer.

5. The semiconductor device of claim 1, 2, 3 or 4, wherein the cavity is at least partially filled with implanted ions.

6. The semiconductor device of claim 1, 2, 3, 4 or 5, wherein the electrical circuitry includes a selected one or more of: a metal routing or a portion of a transistor structure.

7. The semiconductor device of claim 1, 2, 3, 4, 5 or 6, wherein the cavity electrically isolates a first part of the electrical circuitry from a second part of the electrical circuitry.

8. The semiconductor device of claim 1, 2, 3, 4, 5, 6 or 7, wherein the semiconductor device has a first side and a second side opposite the first side, and wherein the cavity has a distance from the first side or the second side that is greater than 100 nm.

9. A method comprising:
providing a semiconductor device;
identifying one or more locations within the semiconductor device;
providing a source for generating accelerated ions; and
altering an operational characteristic of the semiconductor device by generating accelerated ions using the source for generating accelerated ions and focusing the generated accelerated ions on the identified one or more locations within the semiconductor device.

10. The method of claim 9, wherein the source for generating accelerated ions includes a focused ion beam generator.

11. The method of claim 9 or 10, wherein the one or more locations within the semiconductor device includes a selected one or more of: metal circuitry or a transistor structure.

12. The method of claim 9, 10 or 11, wherein the generated accelerated ions include a selected one or more of: helium, lithium, hydrogen, argon, nitrogen, oxygen, silicon, boron, carbon, argon, or neon ions.

13. The method of claim 9, 10, 11 or 12, wherein generating accelerated ions further includes:
identifying a species of ion; and
configuring an energy of the generated accelerated ions.

14. The method of claim 9, 10, 11, 12 or 13, wherein generating accelerated ions further includes identifying a shape of a beam of the generated accelerated ions.

15. The method of claim 9, 10, 11, 12, 13 or 14, wherein generating accelerated ions further includes generating accelerated ions for a duration of time.
